# EUROPÄISCHE PATENTSCHRIFT

(11) **EP 0 813 230 B1**
(45) Veröffentlichungstag und Bekanntmachung des Hinweises auf die Patenterteilung: **26.07.2006**
(21) Anmeldenummer: 97109257.2
(22) Anmeldetag: 07.06.1997
(51) Int. Cl.: H01L 21/00, B08B 5/02, B08B 9/08, B08B 9/34

(54) **Verfahren zum Trockenreinigen von staubverschmutzten Hilfsgegenständen, die zur Handhabung und Aufbewahrung von Halbleiterwafern vorgesehen sind.**
Method for dry cleaning dust soiled objects for carrying and keeping semi-conductor wafers
Procédé de nettoyage par voie sèche d'objets souillés de poussière pour maintenance et stockage de plaquettes semi-conductrices

(30) Priorität: 14.06.1996 DE 19623766
(43) Veröffentlichungstag der Anmeldung: 17.12.1997
(73) Patentinhaber: Micronas Semiconductor Holding AG, 8005 Zürich (CH)
(72) Erfinder: Stroh, Rüdiger Joachim, Dipl.-Ing., 79098 Freiburg (DE); Schweinoch, Bozenka, 79331 Teningen (DE); Trefzer, Martin, 79238 Ehrenkirchen-Kirchhofen (DE); Thomas, Uwe, 79211 Denzlingen (DE); Allmann, Erich, 79297 Winden i.E. (DE); Coad, Craid, Shady Shores, TX 76208 (US)
(74) Vertreter: Göhring, Robert

(56) Entgegenhaltungen:
- EP-A- 0 702 397
- US-A- 4 017 330
- US-A- 4 571 850
- US-A- 5 238 503
- US-A- 5 379 784

## Beschreibung

Die Erfindung betrifft ein Verfahren zum Trockenreinigen von staubverschmutzten Hilfsgegenständen, die zur Handhabung und Aufbewahrung von Halbleiterwafern, insbesondere von staubverschmutzten Quarzhorden, vorgesehen sind.

In der Halbleitertechnologie werden elektronische Bauelemente auf Halbleiterwafern in einer Abfolge von vielen Prozeßschritten unter Reinraumbedingungen hergestellt. Dabei sind Hilfsgegenstände zur Handhabung und Aufbewahrung der Halbleiterwafer notwendig. Für eine gute Ausbeute bei der Herstellung von elektronischen Elementen und um eine gute Qualität der elektronischen Elemente zu erzielen, ist es notwendig, darauf zu achten, daß möglichst keine Staubpartikel auf die Waferoberfläche gelangen. Hierzu ist es erforderlich, daß auch die Hilfsgegenstände zur Handhabung und Aufbewahrung der Halbleiterwafer, die in direkten mechanischen Kontakt mit den Halbleiterwafern kommen, von Staubpartikeln möglichst frei sind; denn Staubpartikel auf den Hilfsgegenständen können sich durch den mechanischen Kontakt auf die Halbleiterwafer übertragen. Ein typisches Beispiel für einen Hilfsgegenstand zur Handhabung von Halbleiterwafern sind die sogenannten "Horden" oder "Carrier", die für bestimmte Anwendungen aus Quarzglas hergestellt sind. Solche Horden bestehen beispielsweise aus vier langen, miteinander verbundenen Quarzstäben, die mit Schlitzen versehen und so angeordnet sind, daß mehrere Halbleiterwafer von einer Quarzhorde aufgenommen werden können, wobei sie in den Schlitzen in einer festen Position stehen. In solchen Quarzhorden werden die Halbleiterwafer zu weiteren Vorrichtungen, beispielsweise in einen Ofen, zur Durchführung eines bestimmten Verfahrensschritts transportiert. Eine Übertragung von Staubpartikeln ensteht in diesem Fall durch den mechanischen Kontakt zwischen dem Halbleiterwafer und der Horde sowie zwischen der Horde und weiteren

Transportgegenständen. Aus diesem Grund werden die Hilfsgegenstände, beispielsweise die Quarzhorden, gereinigt.

In der Praxis ist es dabei üblich, die Hilfsgegenstände mittels einer Stickstoffpistole abzublasen. Dies führt zu dem Nachteil, daß die Staubpartikel in den umgebenden Raum geblasen werden, wo sie sich auf anderen Hilfsgegenständen oder Wafern absetzen können und diese verschmutzen. Zudem hängt die Zuverlässigkeit dieses Prozesses von dem Operator ab, so daß der Reinigungsprozeß nicht gut reproduzierbar ist.

Ferner ist es aus der Praxis bekannt, Hilfsgegenstände, insbesondere Quarzgegenstände, einem nassen Reinigungsverfahren zu unterziehen. Ein derartiges Verfahren ist sehr zeitaufwendig. Zudem wird bei einer Naßreinigung die Oberfläche von Quarzteilen aufgerauht, so daß deren erneute Verschmutzung durch Staubpartikel begünstigt wird.

Aus der EP 07 022 397 A2 ist eine Vorrichtung zum Nassreinigen von staubverschmutzten Waferträgern und ähnlichem bekannt Die Vorrichtung hat eine Aufnahmekammer, in der ein Rotor angeordnet ist, an welchem der zu reinigende Träger befestigt wird. Die Reinigung erfolgt dadurch, dass durch eine Vielzahl von Düsen eine Reinigungsflüssigkeit in den Aufnahmebereich auf den Rotor gesprüht wird. Danach werden die Waferträger mit einem getrockneten Gas, das in den Aufnahmebereich durch eine Vielzahl von Einlassdüsen eingelassen wird, getrocknet. Bevor das Trockengas in die Kammer eingelassen wird, durchläuft es eine Heizvorrichtung, in welcher es erwärmt wird.

Ferner ist aus der US 4 571 850 eine Spül- und Trockenvorrichtung für Halbleiterwaferträger bekannt Ein rotierbarer Rahmen, der den Träger enthält, ist ; direkt mit dem Antriebsmotor verbunden. Träger und drehbarer Rahmen sind in einem Behälter enthalten. Das Innere des Behälters wird von dem Antriebsmotor durch eine Druckgasanordnung so getrennt, dass Verschmutzung verhindert wird.

Die Gaseinlässe sind so angeordnet, dass durch das Gas eine Druckbarriere entsteht, die verhindert, dass Feuchtigkeit und Verschmutzung über die Barriere gelangen.

Der Erfindung liegt die Aufgabe zugrunde, eine verbesserte Reinigungsvorrichtung zu schaffen.

Diese Aufgabe wird durch ein Verfahren mit den Merkmalen des Anspruchs 1 gelöst.

Das Verfahren ermöglicht es, Hilfsgegenstände zur Handhabung und Aufbewahrung von Halbleiterwafern zuverlässig und einfach zu reinigen. Da es sich um eine Trockenreinigungsverfahren handelt, werden die Nachteile des Naßreinigungsverfahrens, insbesondere eine lange Reinigungszeit und ein Aufrauhen der Oberflächen der Hilfsgegenstände vermieden. Dadurch, daß der Hilfsgegenstand zum Trockenreinigen in das verschließbare Gehäuse eingebracht werden kann, wird vermieden, daß weitere Gegenstände oder Wafer in dem Reinraum durch Staubpartikel beschmutzt werden. Die Staubpartikel gelangen vielmehr in den Auffangbereich des Gehäuses, aus dem sie über die Gasabsaugöffnung abgesaugt werden können. Aufgrund einer geeigneten räumlichen Anordnung und Ausbildung der Gaseinlaßdüse und der Gasabsaugöffnung können die Gegenständen in dem Gehäuse zuverlässig und reproduzierbar gereinigt werden. Das Gehäuse kann so ausgebildet werden, daß ein Hilfsgegenstand zum Reinigen darin aufgenommen werden kann; es kann aber auch so ausgebildet werden, daß mehrere Hilfsgegenstände gleichzeitig darin angeordnet und während eines Reinigungszyklusses gereinigt werden können. Die Gaseinlaßdüsen können dann entsprechend in dem Aufnahmebereich verteilt werden.

Gemäß einem bevorzugten Ausführungsbeispiel der Erfindung sind mehrere Gaseinlaßdüsen in dem Aufnahmebereich angeordnet. Dadurch kann der Strom des Reinigungsgases vorteilhafter verteilt werden, so daß der Hilfsgegenstand zuverlässiger umströmt werden kann.

Vorteilhafterweise sind die Gasauslaßöffnungen der Gaseinlaßdüsen in einem vorgegebenen Abstand und/oder Winkel zu einer Fläche des Gehäuses angeordnet. Hierdurch wird auch ein fester Abstand und ein fester Winkel hinsichtlich des zu reinigenden Hilfsgegenstandes vorgegeben. Eine besonders wirksame Reinigung des Hilfsgegenstandes kann dadurch erzielt werden, daß der Abstand der Gasauslaßöffnungen zu dem Hilfsgegenstand sehr klein gewählt wird; er kann beispielsweise in der Größenordnung von 10 mm liegen.

Die Gaseinlaßdüsen können derart angeordnet sein, daß die Gasauslaßöffnung einen unterschiedlichen Abstand von einer Fläche des Gehäuses haben. Auf diese Weise können die Gasauslaßöffnungen an die Form des zu reinigenden Hilfsgegenstandes angepaßt werden. Es kann dadurch erreicht werden, daß der Abstand der Gasauslaßöffnungen zu der ihr gegenüberliegenden Oberfläche des Hilfsgegenstands immer gleich ist. Zur Reinigung einer Quarzhorde, der im wesentlichen vier parallel zueinander verlaufende Stäbe aufweist, die in zwei Ebenen verlaufen, ist es vorteilhaft, vier Reihen von Gaseinlaßdüsen anzuordnen, deren Abstand dem Abstand der Stäbe der Quarzhorde entspricht. Der Abstand der Gaseinlaßdüsen zu der Fläche, von welcher sie ausgehen, wird dabei für jeweils zwei Reihen der Gaseinlaßdüsen konstant gewählt. Der Unterschied zu den beiden anderen Reihen wird entsprechend dem Abstand der beiden Ebenen von je zwei der Quarzstäbe der Horde gewählt. Wenn die Quarzhorde in dem Gehäuse entsprechend positioniert wird, befindet sich jeweils eine Reihe von Gaseinlaßdüsen in einem kurzen, vorgegebenen Abstand über einem Stab der Quarzhorde. In dem Gehäuse kann eine Positioniereinrichtung für den Hilfsgegenstand vorgesehen sein. Diese kann beispielsweise Schienen umfassen. Die Positioniereinrichtung kann so geformt sein, daß sie die Aufnahme verschieden geformter Quarzhorden erlaubt.

Gemäß einem bevorzugten Ausführungsbeispiel der Erfindung sind die Gaseinlaßdüsen in dem Deckel des Gehäuses angeordnet. In einer Gehäusewand, bevorzugerweise in dem Gehäusedeckel, können Kanäle zur Zuführung des Reinigungsgases in die Düsen vorgesehen sein. Dadurch werden unnötige Zuleitungen außerhalb des Gehäuses vermieden.

Bevorzugterweise sind die Gaseinlaßdüsen mit ansteuerbaren Ventilen versehen, und eine Steuereinrichtung ist vorgesehen, mit welcher die Ventile so steuerbar sind, daß durch einzelne Ventile oder durch einzelne Gruppen von Ventilen das Reinigungsgas nach und nach zugeführt werden kann. Dies führt zu einer besonders effektiven Reinigung, da der Gasdruck beim Öffnen eines Ventils am größten ist und während der darauffolgenden Zeit abnimmt. Der beste Reinigungseffekt wird bei einer großen Geschwindigkeit des Reinigungsgases, welches von der jeweiligen Gaseinlaßdüse zu der Gasabsaugöffnung strömt, erreicht. Somit wird bei der gleichen Gasmenge eine größere Gasgeschwindigkeit erreicht, wenn die Ventile nacheinander angesteuert werden.

Gemäß einer vorteilhaften Weiterbildung der Erfindung werden die Ventile mit der Steuereinrichtung so geschaltet, daß das Schließen eines Ventils oder einer Ventilgruppe vor dem Öffnen des nächsten Ventils oder der nächsten Ventilgruppe erfolgt, so daß in einem kurzen Zeitabschnitt dem Gehäuse kein Reinigungsgas zugeführt wird. Hierdurch kann sich in den Kanälen der zu öffnenden Ventile wieder der gesamte Druck vor dem Öffnen aufbauen, so daß eine größere Geschwindigkeit des Reinigungsgases erzielt wird. Die Steuereinrichtung kann auch derart ausgebildet sein, daß die Gaseinlaßdüsen während eines Reinigungsvorganges mehrfach ansteuerbar sind.

Erfindungsgemäß ist in dem Auffangbereich des Gehäuses ein Regulierventil zum Einlassen von Umgebungsluft vorgesehen. Die Umgebungsluft wird dann gleich durch die Gasabsaugöffnung abgesaugt, so daß sie lediglich in den Auffangbereich des Gehäuses und nicht in den Aufnahmebereich gelangt. Durch diese Anordnung wird die Geschwindigkeit des Remigungsgases, welches durch das Gehäuse strömt, weiter vergrößert. Das weiteren ist, an die Gasabsaugöffnung eine Pumpeinrichtung angeschlossen sein, mittels welcher eine Absaugleistung zum Aufbauen eines Unterdrucks in dem Auffangbehälter erzielbar ist. Durch diesen Unterdruck wird die Menge der Umgebungsluft mitbestimmt, die über das Regulierventil in den Auffangbereich hineingelassen wird.

Statt Umgebungsluft kann auch Reinigungsgas zugeführt werden, das zu diesem Zweck aus einem Druckausgleichsbehälter strömt, in dem ein Gasdruck herrscht, der etwas höher als der Umgebungsluftdruck ist, und deutlich niedriger als der Gasdruck vor den Ventilen. Dadurch wird die Partikelverschmutzung des Reinigungsgerätes minimiert und die Strömung des aus den Ventilen einströmenden Gases nicht gestört.

Ferner können die Gaseinlaßdüsen mit der Steuereinrichtung elektronisch steuerbar sein. Das Gehäuse kann ein Schaltelement umfassen, das bei Schließen des Gehäuses mit dem Deckel betätigt wird und den Reinigungsvorgang startet. Zur Gewährleistung eines konstanten und regulierbaren Druckes kann in einer mit den Kanälen verbundenen Gaszuleitung eine Druckreglereinrichtung vorgesehen sein.

Auch ist es vorteilhaft, wenn das Gehäuse aus einem antistatischen Material gebildet ist, da dadurch elektrische Aufladungen beim Durchströmen des Reinigungsgases verhindert werden. Hierdurch wird wiederum ein Ionisieren des das Gehäuse durchströmenden Reinigungsgases verhindert. Die elektrostatische Aufladung kann auch durch in der Gaszuleitung vorgesehene Ionisatoren verhindert werden, welche zur Gasreinigung dienen. Durch eines der beiden oder durch die Kombination beider Verfahren kann das Anlagern von Staubpartikeln am Reinigungsgerät und an der Quarzhorde aufgrund von elektrostatischer Anziehung minimiert und das Loslösen von elektrostatisch anhaftenden Partikeln begünstigt werden.

Im folgenden wird die Erfindung anhand der Zeichnung näher erläutert.

### Es zeigen:

Fig. 1 einen Querschnitt durch ein erfindungsgemäßes Gehäuse, in dem eine Horde angeordnet ist und

Fig. 2 eine Draufsicht auf einen Deckel des Gehäuses aus Fig. 1.

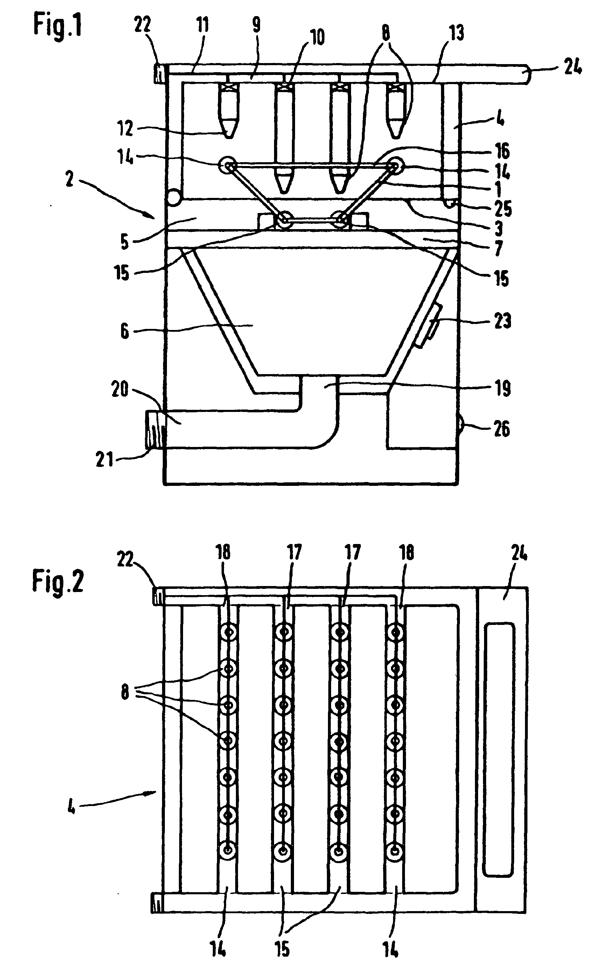

Fig. 1 zeigt eine Vorrichtung zum Trockenreinigen einer staubverschmutzten Horde 1. Die Vorrichtung besteht aus einem Gehäuse 2, das eine Aufnahmeöffnung 3 aufweist, welche mit einem Deckel 4 verschließbar ist. Das Gehäuse 2 enthält einen Aufnahmebereich 5 für eine Horde 1 und ein von diesem räumlich getrennten Auffangbereich 6. In dem Aufnahmebereich 5 ist eine Auflageeinrichtung 7 vorgesehen, auf der die Horde 1 positioniert werden kann. Die Auflageeinrichtung 7 kann aus geeignet angeordneten Schienen bestehen. Ferner sind in dem Aufnahmebereich 5 Gasauslaßdüsen 8 vorgesehen. Die Gasauslaßdüsen 8 sind in dem Deckel 4 des Gehäuses 2 angeordnet. Sie sind mit Kanälen 9 zur Zuführung des Reinigungsgases verbunden. Ferner weisen die Gasauslaßdüsen 8 Ventile 10 auf, die über eine Steuerleitung 11 ansteuerbar sind. Die Gaseinlaßdüsen 8 sind auf einer Fläche 13 des Deckels 4 so positioniert, daß sich die Gasauslaßöffnungen 12 in einem festen Abstand von der Fläche 13 befinden. Dieser Abstand ist so gewählt, daß ein vorgegebener Abstand der Gasauslaßöffnungen 12 zu der Horde 1 festgelegt wird. Die Horde 1 besteht aus vier Stäben 14 und 15, die aus Quarz bestehen können. Sie sind mit einer Verbindungseinrichtung 16 miteinander verbunden. Jeweils zwei der Stäbe 14, 15 sind in einer horizontalen Ebene angeordnet. Die Gaseinlaßdüsen 8 sind so angeordnet, daß ihre Gasauslaßöffnungen 12 einen festen Abstand zu einem der Stäbe 14,15 aufweisen.

Wie man Fig. 2 entnimmt, sind die Gaseinlaßdüsen 8 in vier Reihen 17,18 angeordnet. Die Gaseinlaßdüsen 8 der äußeren Reihen 18 sind kürzer als die Gaseinlaßdüsen 8 der inneren Reihen 17. Mit den Gaseinlaßdüsen 8 der äußeren Reihen 18 werden die äußeren Stäbe 14 in der oberen horizontalen Ebene der Horde 1 gereinigt, mit den Gaseinlaßdüsen 8 der inneren Reihen 17 werden die Stäbe 15 in der unteren horizontalen Ebene der Horde 1 gereinigt. Der Auffangbereich 6 weist eine Gasabsaugöffnung 19 auf, von welcher eine Gasabsaugleitung 20 nach außen führt. An der Außenseite des Gehäuses 2 ist ein Anschluß 21 für eine Absaugeinrichtung, wie eine Pumpe, ein Staubsauger oder ähnliches vorgesehen. Am Deckel 4 sind Anschlüsse 22 für die Zuführung des Reinigungsgases sowie Anschlüsse für die Steuerung der Ventile 10 vorgesehen. Der Auffangbereich 6 ist ferner mit einem Regulierventil 23 zum Einlassen von Umgebungsluft versehen.

Fig. 2 zeigt eine Draufsicht auf den Deckel 4 aus Fig. 1. Entlang der Breite des Deckels sind die Gaseinlaßdüsen 8 in den vier Reihen 17, 18 angeordnet. Sie befinden sich oberhalb der Stäbe 15, 16 der Horde 1, so daß die gesamte Länge der Stäbe 14, 15 gereinigt werden kann. Der Deckel 4 weist einen Griff 24 auf, mit dem das Gehäuse 2 geöffnet und geschlossen werden kann.

Im folgenden wird die Funktionsweise der erfindungsgemäßen Vorrichtung erläutert. Mit dem Griff 24 wird der Deckel 4 des Gehäuses 2 geöffnet. Die Horde 1 wird durch die Aufnahmeöffnung 3 in den Aufnahmebereich 5 eingebracht und auf der Auflageeinrichtung 7 positioniert. Dann wird der Deckel 4 des Gehäuses 2 geschlossen. Durch das Schließen wird ein Schalter 25 betätigt, der den Reinigungsvorgang startet. Es wird dadurch ebenfalls eine Kontrollampe 26 eingeschaltet, die anzeigt, daß das Reinigungsverfahren durchgeführt wird. Beim Starten des Reinigungsvorganges wird ein Reinigungsgas in die Kanäle 9 geleitet. Der Druck des Reinigungsgases kann durch einen Druckminderer in der Zuführleitung vorgegeben werden. Es soll bei dem Reinigungsvorgang eine möglichst große Geschwindigkeit des Reinigungsgases in dem Gehäuse 2 erzielt werden, da dann der Reinigungseffekt am größten ist. Es werden durch eine in der Figur nicht gezeigte Steuereinrichtung die Ventile 10 der Gaseinlaßdüsen 8 nacheinander in einer vorgegebenen Reihenfolge, beispielsweise reihenweise, angesteuert. Das erste Ventil wird für einen vorgegebenen Zeitraum Z1 geöffnet und danach geschlossen.. Das zweite Ventil wird nach einem Zeitraum Z2 geöffnet, nach welchem sich wieder der ursprüngliche Druck in den Kanälen 9 aufgebaut hat. Das zweite Ventil wird für einen weiteren Zeitraum Z1 der gleichen Länge wie im Fall des ersten Ventils geöffnet und danach geschlossen. Nach dem Zeitraum Z2, nach dem sich der Druck wieder aufgebaut hat, wird das dritte Ventil geöffnet. Dieser Prozeß wird von der Steuereinrichtung so lange fortgesetzt, bis alle Ventile betätigt worden sind. Danach kann wieder mit dem ersten Ventil begonnen werden. Der Reinigungsvorgang kann so mehrmals hintereinander durchgeführt werden. Die Länge der Zeiträume für das Öffnen der Ventile und für die Pause nach dem Schließen des einen bis zum Öffnen des anderen Ventils sowie die Anzahl der Reinigungszyklen wird vorher festgelegt und an die Bedingungen des Einzelfalls angepaßt. Bedingungen hierfür sind der Verschmutzungsgrad der Horde, der Druck in der Gaszuleitung, Absaugleistung, Anzahl der Ventile etc..

Mit dem Einschalten des Reinigungsvorganges wird ebenfalls das Absaugen durch die Gasabsaugöffnung 9 in Gang gesetzt. Die Absaugleistung ist dabei so gewählt, daß in dem Auffangbereich 6 ein Unterdruck entsteht. Durch das Regulierventil 23 wird Umgebungsluft in den Auffangbereich 6 hineingelassen, die so dosiert wird, daß sie von einer nichtgezeigten Absaugeinrichtung ebenfalls durch die Gasabsaugöffnung 19 abgesaugt wird. Das aus den Gaseinlaßdüsen 8 austretende Reinigungsgas strömt um die Stäbe 15, 16 der Horde 1, gelangt in den Auffangbereich 6 und wird dort abgesaugt. Durch den Unterdruck in dem Auffangbereich 6 und durch die durch das Regulierventil 23 einströmende Umgebungsluft werden in dem Reinigungsgas zusätzliche Turbulenzen erzeugt, die Gaspartikel werden beschleunigt, so daß sie eine höhere Geschwindigkeit erhalten. Je höher diese Geschwindigkeit eingestellt werden kann, desto effektiver ist der Reinigungsprozeß. Die auf der Horde 1 sitzenden Staubpartikel, die von dem Reinigungsgas abgeblasen werden, fallen in den Auffangbereich 6, wo sie durch die Gasabsaugöffnung 19 abgesaugt werden. Aufgrund des dort herrschenden Unterdrucks und aufgrund der Strömung durch die eintretende Umgebungsluft werden die Staubpartikel mitgerissen, und ein Aufwirbeln durch das sie wieder in den Aufnahmebereich 5 gelangen könnten, wird verhindert. Wenn der Reinigungsvorgang abgeschlossen ist, wird die Kontrollampe 26 von der Steuereinrichtung ausgeschaltet. Danach wird der Deckel 4 des Gehäuses 2 geöffnet und die gereinigte Horde 1 entnommen. Eine andere Horde 1 kann zum Reinigen in den Aufnahmebereich 5 eingebracht werden und das beschriebene Verfahren von neuem begonnen werden.

## Patentansprüche

1. Verfahren zum Trockenreinigen von staubverschmutzten Hilfsgegenständen, die zur Handhabung und Aufbewahrung von Halbleiterwafern vorgesehen sind, insbesondere von staubverschmutzten Quarzhorden (1), mittels einer Vorrichtung, die ein Gehäuse (2) mit einer mittels eines Deckels (4) verschließbaren Aufnahmeöffnung (3) umfasst, in dem Gehäuse (2) ein Aufnahmebereich (5) für einen Hilfsgegenstand und ein von diesem räumlich getrennter Auffangbereich (6) vorgesehen sind, und in dem Aufnahmebereich (5) wenigstens eine Gaseinlassdüse (8) und in dem Auffangbereich (6) eine Gasabsaugöffnung (19) derart angeordnet sind, dass der Hilfsgegenstand während der Reinigung von einem Reinigungsgas umströmt wird, wobei an die Gasabsaugöffnung (19) eine Pumpeinrichtung angeschlossen ist und wobei im Auffangbereich (6) mittels der Pumpeinrichtung ein Unterdruck erzeugt wird und im Auffangbereich (6) ein Regulierventil (23) vorgesehen ist, mit welchem während der Reinigung Umgebungsluft eingelassen wird, die so dosiert ist, dass sie von der Pumpeinrichtung durch die Gasabsaugöffnung zusammen mit dem Reinigungsgas abgesaugt wird, so dass im Reinigungsgas zusätzlich Turbulenzen erzeugt werden.

2. Verfahren nach Anspruch 1,
**dadurch gekennzeichnet, dass** mehrere Gaseinlassdüsen (8) in dem Aufnahmebereich (5) angeordnet sind.

3. Verfahren nach Anspruch 1 oder 2,
**dadurch gekennzeichnet, dass** die Gasauslassöffnungen (12) der Gaseinlassdüsen (8) in einem vorgegebenen Abstand und/oder Winkel zu einer Fläche des Gehäuses (2) angeordnet sind.

4. Verfahren nach einem der vorangehenden Ansprüche,
**dadurch gekennzeichnet, dass** die Gaseinlassdüsen (8) derart angeordnet sind, dass die Gasauslassöffnungen (12) einen unterschiedlichen Abstand von einer Fläche des Gehäuses (2) haben.

5. Verfahren nach einem der vorangehenden Patentansprüche,
**dadurch gekennzeichnet, dass** die Gaseinlassdüsen (8) in dem Deckel (4) des Gehäuses (2) angeordnet sind.

6. Verfahren nach einem der vorangehenden Patentansprüche,
**dadurch gekennzeichnet, dass** die Gaseinlassdüsen (8) relativ zu einer Fläche des Gehäuses (2) bewegbar sind.

7. Verfahren nach einem der vorangehenden Patentansprüche,
**dadurch gekennzeichnet, dass** in einer Gehäusewand, bevorzugterweise in dem Gehäusedeckel (2), Kanäle (9) zur Zuführung des Reinigungsgases in die Gaseinlassdüsen (8) vorgesehen sind.

8. Verfahren nach einem der vorangehenden Ansprüche,
**dadurch gekennzeichnet, dass** die Gaseinlassdüsen (8) mit ansteuerbaren Ventilen (10) versehen sind, und eine Steuereinrichtung vorgesehen ist, mit welcher die Ventile (10) so steuerbar sind, dass durch einzelne Ventile (10) oder durch einzelne Gruppen von Ventilen (10) das Reinigungsgas nacheinander zugeführt werden kann.

9. Verfahren nach Anspruch 8,
**dadurch gekennzeichnet, dass** die Ventile (10) mit der Steuereinrichtung so geschaltet werden, dass das Schließen eines Ventils (10) oder einer Gruppe von Ventilen vor dem Öffnen des nächsten Ventils (10) oder der nächsten Ventilgruppe erfolgt, so dass in einem kurzen Zeitabschnitt dem Gehäuse kein Reinigungsgas zugeführt wird.

10. Verfahren nach Anspruch 8 oder 9,
**dadurch gekennzeichnet, dass** die Steuereinrichtung derart ausgebildet ist, dass die Gaseinlassdüsen (8) während eines Reinigungsvorganges mehrfach ansteuerbar sind.

11. Verfahren nach einem der vorangehenden Ansprüche,
**dadurch gekennzeichnet, dass** das Gehäuse (2) ein Schaltelement (25) umfasst, das bei Schließen des Gehäuses (2) mit dem Deckel (4) betätigt wird und den Reinigungsvorgang startet.

12. Verfahren nach einem der vorangehenden Ansprüche,
**dadurch gekennzeichnet, dass** in einer mit den Kanälen (9) verbundenen Gaszuleitung eine Druckreglereinrichtung vorgesehen ist.

13. Verfahren nach einem der vorangehenden Ansprüche,
**dadurch gekennzeichnet, dass** das Gehäuse (2) aus einem antistatischen Material gebildet ist.

## Claims

1. A method for dry cleaning dust-contaminated auxiliary objects which are provided for handling and storing semiconductor wafers, in particular dust-contaminated quartz baskets (1), by means of an apparatus comprising a housing (2) with a receiving aperture (3) closable by means of a lid (4), a receiving area (5) for an auxiliary object and a collecting area (6) spatially separated therefrom are provided in the housing (2), and at least one gas inlet nozzle (8) is disposed in the receiving area (5) and a gas extraction aperture (19) is disposed in the collecting area (6) in such a manner that a cleaning gas flows around the auxiliary object during cleaning, whereby a pump device is connected to the gas extraction aperture (19) and whereby a partial vacuum is produced in the collecting area (6) and a regulating valve (23) is provided in the collecting area (6), with which ambient air is admitted during cleaning, said ambient air being metered so that it is extracted by the pumping device through the gas extraction aperture together with the cleaning gas so that turbulence is additionally produced in the cleaning gas.

2. A method according to Claim 1,
**characterised in that** several gas inlet nozzles (8) are disposed in the receiving area (5).

3. A method according to Claim 1 or 2,
**characterised in that** the gas outlet apertures (12) of the gas inlet nozzles (8) are disposed at a predetermined distance and/or angle from a surface of the housing (2).

4. A method according to one of the preceding Claims,
**characterised in that** the gas inlet nozzles (8) are disposed such that the gas outlet apertures (12) have varying spacing from a surface of the housing (2).

5. A method according to one of the preceding Patent Claims,
**characterised in that** the gas inlet nozzles (8) are disposed in the lid (4) of the housing (2).

6. A method according to one of the preceding Patent Claims,
**characterised in that** the gas inlet nozzles (8) can move relative to a surface of the housing (2).

7. A method according to one of the preceding Patent Claims,
**characterised in that** channels (9) for supplying the cleaning gas to the gas inlet nozzles (8) are provided in a housing wall, preferably in the housing lid (2).

8. A method according to one of the preceding Claims,
**characterised in that** the gas inlet nozzles (8) are provided with actuatable valves (10), and a control device is provided with which the valves (10) can be controlled so that the cleaning gas can be supplied consecutively by individual valves (10) or by individual groups of valves (10) .

9. A method according to Claim 8,
**characterised in that** the valves (10) are switched with the control device so that the closing of a valve (10) or of a group of valves takes place prior to the opening of the next valve (10) or of the next group of valves so that no cleaning gas is supplied to the housing for a brief time segment.

10. A method according to Claim 8 or 9,
**characterised in that** the control device is designed in such a manner that the gas inlet nozzles (8) can be actuated several times during a cleaning process.

11. A method according to one of the preceding Claims,
**characterised in that** the housing (2) comprises a switching element (25) which is actuated when closing the housing (2) with the lid (4) and starts the cleaning process.

12. A method according to one of the preceding Claims,
**characterised in that** a pressure regulating device is provided in a gas inlet pipe connected to the channels (9).

13. A method according to one of the preceding Claims,
**characterised in that** the housing (2) is made from an antistatic material.

## Revendications

1. Procédé pour le nettoyage à sec d'objets accessoires souillés de poussières prévus pour le maniement et la conservation de plaquettes à semi-conducteurs, en particulier de claies en quartz (1) souillées de poussières, au moyen d'un dispositif qui comprend un boîtier (2) avec une ouverture de logement (3) pouvant être fermée par un couvercle (4), et logeant une zone de logement (5) pour un objet accessoire et une zone de récupération (6) spatialement séparée de celle-ci avec au moins une buse d'injection de gaz (8) disposée dans la zone de logement (5) ainsi qu'une ouverture d'aspiration de gaz (19) dans la zone de récupération (6), de sorte que pendant le nettoyage l'objet accessoire est entouré par un gaz de nettoyage, un dispositif de pompe étant raccordé à l'ouverture d'aspiration de gaz (19), pour générer une dépression dans la zone de récupération (6), et avec une soupape de régulation (23) prévue dans la zone de récupération (6) pour introduire de l'air ambiant pendant le nettoyage, dosé de sorte à être aspiré, conjointement avec le gaz de nettoyage, par le dispositif de pompe à travers l'ouverture d'aspiration de gaz, de sorte que des turbulences supplémentaires sont générées dans le gaz de nettoyage.

2. Procédé selon la revendication 1,
**caractérisé en ce que**
plusieurs buses d'injection de gaz (8) sont disposées dans la zone de logement (5).

3. Procédé selon la revendication 1 ou 2,
**caractérisé en ce que**
les ouvertures de sortie de gaz (12) des buses d'injection de gaz (8) sont disposées à une distance prédéfinie et/ou dans un angle prédéfini par rapport à une surface du boîtier (2).

4. Procédé selon l'une quelconque des revendications précédentes,
**caractérisé en ce que**
les buses d'injection de gaz (8) sont disposées de telle sorte que les ouvertures de sortie de gaz (12) présentent une distance différente par rapport à une surface du boîtier (2).

5. Procédé selon l'une quelconque des revendications précédentes,
**caractérisé en ce que**
les buses d'injection de gaz (8) sont disposées dans un couvercle (4) du boîtier (2).

6. Procédé selon l'une quelconque des revendications précédentes,
**caractérisé en ce que**
les buses d'injection de gaz (8) sont mobiles par rapport à une surface du boîtier (2).

7. Procédé selon l'une quelconque des revendications précédentes,
**caractérisé en ce que**
dans une paroi de boîtier, de préférence dans le couvercle du boîtier (2) des canaux (9) sont prévus pour amener le gaz de nettoyage dans les buses d'injection de gaz (8).

8. Procédé selon l'une quelconque des revendications précédentes,
**caractérisé en ce que**
les buses d'injection de gaz (8) sont munies de soupapes (10) commandables, et un dispositif de commande est prévu pour commander les soupapes (10) de manière à amener le gaz de nettoyage successivement par des soupapes (10) individuelles ou des groupes individuels de soupapes (10).

9. Procédé selon la revendication 8,
**caractérisé en ce que**
les soupapes (10) sont commutées par le dispositif de commande de telle sorte que la fermeture d'une soupape (10) ou d'un groupe de soupapes s'effectue avant l'ouverture de la soupape (10) suivante ou du groupe de soupapes suivant, de manière à ce que pendant un court laps de temps aucun gaz de nettoyage ne soit amené dans le boîtier.

10. Procédé selon la revendication 8 ou 9,
**caractérisé en ce que**
le dispositif de commande est conçu pour permettre de commander les buses d'injection de gaz (8) plusieurs fois pendant un processus de nettoyage.

11. Procédé selon l'une quelconque des revendications précédentes,
**caractérisé en ce que**
le boîtier (2) comprend un élément de commutation (25) qui, par le couvercle (4) actionné lors de la fermeture du boîtier (2) démarre le processus de nettoyage.

12. Procédé selon l'une quelconque des revendications précédentes,
**caractérisé en ce qu'**
un dispositif régulateur de pression est prévu dans une conduite d'amenée de gaz reliée aux canaux (9).

13. Procédé selon l'une quelconque des revendications précédentes,
**caractérisé en ce que**
le boîtier (2) est fabriqué à partir d'un matériau antistatique.
